# EUROPEAN PATENT APPLICATION

(11) **EP 4 734 694 A1**
(43) Date of publication of application: **29.04.2026**
(21) Application number: 23948270.6
(22) Date of filing: 21.11.2023
(51) Int. Cl.: H10B 41/30, H10B 41/42, H10B 41/50

(54) **MANUFACTURING METHOD FOR MEMORY DEVICE, AND MEMORY DEVICE**

(30) Priority: 07.08.2023 CN 202310993856
(71) Applicant: Wuhan Xinxin Semiconductor Manufacturing Co., Ltd., Wuhan, Hubei 430205 (CN)
(72) Inventor: MAO, Zhou, Wuhan, Hubei 430205 (CN); CAO, Kaiwei, Wuhan, Hubei 430205 (CN)
(74) Representative: De Arpe Tejero, Manuel
(86) International application number: PCT/CN2023/133012
(87) International publication number: WO 2025/030708

(57) **Abstract**

Disclosed in the present invention are a manufacturing method for a memory device, and a memory device. The manufacturing method comprises: providing a semiconductor substrate, comprising a base and a first groove formed from the surface of the base to the base; forming a gate insulating layer and a first gate material layer on the surface of the base and in the first groove, or forming the gate insulating layer and the first gate material layer in the first groove; removing part of the first gate material layer and part of the gate insulating layer to form a contact window on the surface of the base or the sidewall of the first groove; forming a second gate on the contact window, wherein the second gate is in contact with the base, and a continuous lattice configuration is formed between the second gate and the base; and forming an island-shaped structure, wherein the residual first gate material layer in the island-shaped structure serves as a first gate, the first gate is in contact with the second gate and is separated from the base by means of the gate insulating layer, and the first gate and the second gate form a semi-floating gate of a memory cell in the memory device. Therefore, the present application can effectively improve the interface flatness of the contact window in a semi-floating gate structure, and improve the storage performance of the memory device.

## Description

### CROSS REFERENCE TO RELATED APPLICATIONS

The present disclosure claims priority to Chinese Patent Application No. 202310993856.2, filed on August 07, 2023, the entire contents of this application are incorporated herein by reference.

### TECHNICAL FIELD

The present disclosure relates to the field of semiconductor technology, and in particular to a manufacturing method for a memory device and a memory device.

### BACKGROUND

In the fabrication of integrated circuits, the performance of various devices, especially memory devices, is affected by the interfaces between different material layers. Variations in the flatness of these interfaces can adversely affect the storage performance of the memory devices.

In the practical operation process, the researchers of the present disclosure observed that manufacturing schemes of memory devices in related art, etching is generally used to form a contact window to expose a substrate, thereby forming a semi-floating gate structure. However, during the process of forming the semi-floating gate structure, an interface at the contact window may become uneven, which affects the storage performance of the memory devices.

### SUMMARY

Embodiments of the present disclosure provide a manufacturing method for a memory device and a memory device.

The present disclosure provides a manufacturing method for a memory device, including: providing a semiconductor base, the semiconductor base including a substrate and a first trench formed from a surface of the substrate toward the substrate; forming a gate insulating layer and a first gate material layer on the surface of the substrate and in the first trench, or forming a gate insulating layer and a first gate material layer in the first trench, the first gate material layer filling the first trench; removing a part of the first gate material layer and a part of the gate insulating layer to form a contact window on the surface of the substrate or on a sidewall of the first trench, and forming a second gate on the contact window, the second gate contacting the substrate and having a continuous lattice structure with the substrate; forming an island structure, the island structure covering the first trench, a portion of the first gate material layer remaining in the island structure serving as a first gate, the first gate contacting the second gate and being separated from the substrate by the gate insulating layer, and the first gate and the second gate constituting a semi-floating gate of a memory cell in the memory device.

On the other hand, the present disclosure provides a memory device, including: a substrate; a trench, extending from a surface of the substrate toward the substrate; an island structure, at least filling the trench, the island structure including a first gate and a second gate, the second gate contacting the substrate through a contact window and having a continuous lattice structure with the substrate, the first gate being separated from the substrate by a gate insulating layer, the first gate and the second gate contacting with each other and constituting a semi-floating gate of a memory cell in the memory device, and the contact window being located on the surface of the substrate or on a sidewall of the trench.

Details of one or more embodiments of the present disclosure are set forth in the accompanying drawings and the description below. Other features, objects, and advantages of the present disclosure will become apparent from the description, the drawings, and claims.

### BRIEF DESCRIPTION OF THE DRAWINGS

In order to more clearly illustrate the technical solutions in the embodiments of the present disclosure, a brief introduction will be provided below for the drawings required in the embodiments. It is apparent that the drawings described herein are merely some embodiments of the present disclosure. For those skilled in the art, other drawings may be obtained according to the drawings without inventive effort.
FIG. 1 is a schematic flow chart of a manufacturing method for a memory device according to a first embodiment of the present disclosure.
FIG. 2 is a schematic structural diagram of a semiconductor base according to an embodiment of the present disclosure.
FIG. 3 is a schematic structural diagram of forming a gate insulating layer and a first gate material layer according to a first embodiment of the present disclosure.
FIG. 4 is a schematic structural diagram of forming a contact window according to a first embodiment of the present disclosure.
FIG. 5 is a schematic structural diagram of growing a second gate according to a first embodiment of the present disclosure.
FIG. 6 is a schematic structural diagram of continuously forming a first gate material according to a first embodiment of the present disclosure.
FIG. 7 is a schematic structural diagram of patterning a first gate material layer according to a first embodiment of the present disclosure.
FIG. 8 is a schematic structural diagram of forming an inter-gate dielectric layer according to a first embodiment of the present disclosure.
FIG. 9 is a schematic structural diagram of forming a third gate material layer according to a first embodiment of the present disclosure.
FIG. 10 is a schematic structural diagram of forming an island structure according to a first embodiment of the present disclosure.
FIG. 11 is a schematic structural diagram of forming a gate insulating layer and a first gate material layer according to a second embodiment of the present disclosure.
FIG. 12 is a schematic structural diagram of forming a contact window according to a second embodiment of the present disclosure.
FIG. 13 is a schematic structural diagram of forming a second gate according to a second embodiment of the present disclosure.
FIG. 14 is a schematic structural diagram of forming an inter-gate dielectric layer and a third gate material layer according to a second embodiment of the present disclosure.
FIG. 15 is a schematic structural diagram of forming an island structure according to a second embodiment of the present disclosure.
FIG. 16 is a schematic structural diagram of forming an inter-gate dielectric layer and a third gate material layer according to a third embodiment of the present disclosure.

### Reference numerals.

semiconductor base 100; substrate 110; first trench 101; gate insulating layer 200; first gate material layer 300; second trench 201; first gate 310; second gate 400; inter-gate dielectric layer 500; third gate material layer 600; third gate 610.

### DETAILED DESCRIPTION

The technical solutions in embodiments of the present disclosure will be clearly and completely described below in conjunction with the accompanying drawings in the embodiments of the present disclosure, and it is obvious that the described embodiments are only a part of the embodiments of the present disclosure, but not all of them. Based on the embodiments of the present disclosure, all other embodiments obtained by those skilled in the art without creative labor fall within the protection scope of the present disclosure.

The terms "first", "second", and "third" in the present disclosure are intended for descriptive purposes only and are not to be construed as indicating or implying relative importance or implicitly indicating the number of indicated technical features. Therefore, a feature defined with "first", "second", or "third" may explicitly or implicitly include at least one such feature. In the description of the present disclosure, the terms "a plurality of" or "multiple" means at least two, e.g., two, three, etc., unless otherwise expressly and specifically limited. All directional indications (e.g., up, down, left, right, forward, backward... ) in the present disclosure are intended only to explain relative position relationships, movement situations, etc., between components in a particular posture (as shown in the accompanying drawings). If the particular posture is changed, the directional indications are changed accordingly. In addition, the terms "include" and "have", and any variations thereof are intended to cover non-exclusive inclusion. For example, a process, method, system, product, or device including a series of steps or units is not limited to the listed steps or units, but optionally further includes steps or units not listed, or optionally further includes other steps or units inherent to the process, method, product, or device.

References herein to the term "embodiment" mean that particular features, structures, or characteristics described in conjunction with an embodiment may be included in at least one embodiment of the present disclosure. The presence of the phrase at various positions in the specification does not necessarily mean the same embodiment, nor is it a separate or alternative embodiment that is mutually exclusive with other embodiments. It is understood, both explicitly and implicitly, by those skilled in the art that the embodiments described herein may be combined with other embodiments.

The present disclosure is described in detail below in conjunction with the accompanying drawings and embodiments.

In related art, electrons of a traditional floating gate transistor tunnel through a silicon dioxide insulating dielectric layer with a band gap of 8.9 eV and a high energy barrier, while electrons of a semi-floating gate transistor tunnel through a silicon material with a band gap of 1.1 eV. A tunneling barrier is greatly reduced, enabling faster data writing and erasing at low voltages, which meets low power consumption requirements of chips. In a manufacturing process for a memory device, etching is generally used to form a contact window to expose a substrate, thereby forming a semi-floating gate structure. However, during the process of forming the semi-floating gate structure, the etching process may lead to an uneven interface at the contact window and may cause damage to the substrate. When the memory device is in operation, it is affected by trapped charges at the damaged contact window interfaces, which may cause significant variations in data retention time and thereby affect the storage performance of the memory device.

Therefore, a manufacturing method for a memory device is provided, which may effectively improve an interface flatness of the contact window in the semi-floating gate structure and enhance the storage performance of the memory device.

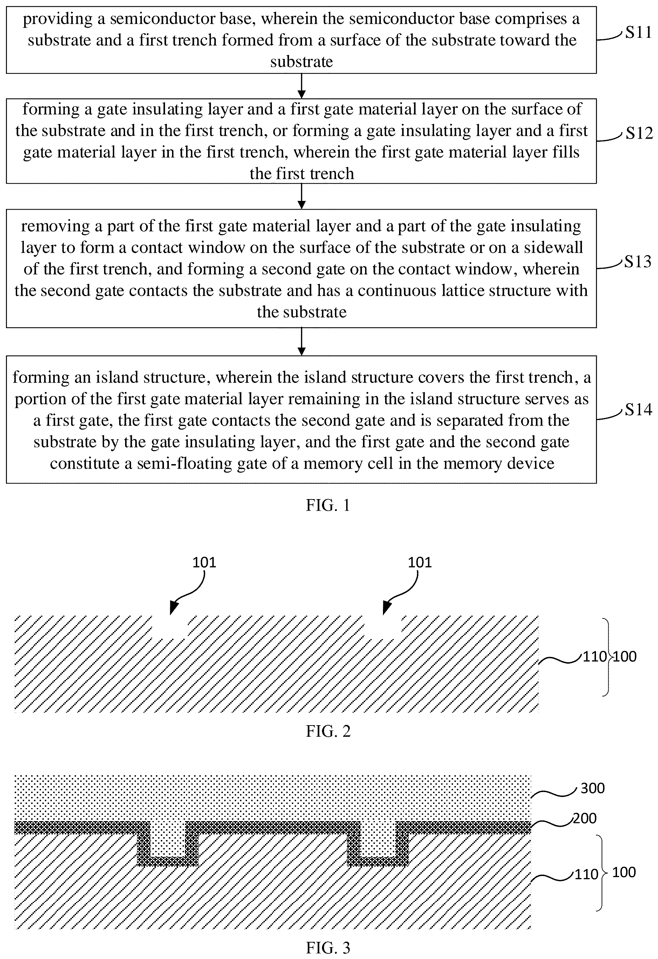

As shown in FIG. 1, FIG. 1 is a schematic flow chart of a manufacturing method for a memory device according to some embodiments of the present disclosure.

As shown in FIG. 1, the manufacturing method for the memory device provided by the present disclosure may include the operations executed by the following blocks.

At block S11, a semiconductor base is provided, and the semiconductor base includes a substrate and a first trench formed from a surface of the substrate toward the substrate.

At block S12, a gate insulating layer and a first gate material layer are formed on the surface of the substrate and in the first trench, or a gate insulating layer and a first gate material layer are formed in the first trench, and the first gate material layer fills the first trench.

At block S13, a part of the first gate material layer and a part of the gate insulating layer are removed to form a contact window on the surface of the substrate or on a sidewall of the first trench, and a second gate is formed on the contact window, and the second gate contacts the substrate and has a continuous lattice structure with the substrate.

At block S14, an island structure is formed, the island structure covers the first trench, a portion of the first gate material layer remaining in the island structure serves as a first gate, the first gate contacts the second gate and is separated from the substrate by the gate insulating layer, and the first gate and the second gate constitute a semi-floating gate of a memory cell in the memory device.

The following FIG. 2 to FIG. 10 are schematic structural diagrams of the manufacturing method for the memory device according to a first embodiment of the present disclosure.

Block S11 in the embodiment may include the following operations.

The semiconductor base is provided. The semiconductor base includes the substrate and the first trench formed from the surface of the substrate toward the substrate.

The substrate may be any suitable substrate material known in the related art. For example, the substrate may be at least one of the following materials: silicon (Si), germanium (Ge), silicon germanium (SiGe), silicon carbon (SiC), silicon germanium carbon (SiGeC), indium arsenide (InAs), gallium arsenide (GaAs), indium phosphide (InP), or other III/V compound semiconductors, including multilayer structures composed of these semiconductors. Alternatively, the substrate may be silicon on insulator (SOI), stacked silicon on insulator (SSOI), stacked silicon germanium on insulator (S-SiGeOI), silicon germanium on insulator (SiGeOI), or germanium on insulator (GeOI).

As shown in FIG. 2, FIG. 2 is a schematic structural diagram of a semiconductor base according to an embodiment of the present disclosure.

The semiconductor base 100 includes the substrate 110 and the first trench 101 formed from the surface of the substrate 110 toward the substrate 110.

In some embodiments, multiple doped regions may be formed by implanting ions into the substrate 110, thereby making the substrate 110 have the doped regions. For example, the substrate includes a deep P-type well region and an N-type well region on the deep P-type well region. The first trench 101 extends into the substrate, and a bottom of the first trench 101 exposes a portion of the deep P-type well region.

In some embodiments, the gate insulating layer 200 may be a nitride layer, an oxide layer, an oxynitride layer, etc., such as at least one of silicon nitride, silicon oxide, and silicon oxynitride. In the following embodiments, the gate insulating layer 200 is silicon oxide.

In some embodiments, a plurality of first trenches 101 are formed spaced apart in a plurality of active areas from the surface of the substrate 110 toward the substrate 110. The first trenches 101 are distributed in sequence along a second direction. In a first direction, the active areas are defined by multiple shallow trench isolation structures. The first direction and the second direction are perpendicular to each other in the same horizontal plane.

Block S12 in the embodiment may include the following operations.

The gate insulating layer and the first gate material layer are formed on the surface of the substrate and in the first trench. The first gate material layer fills the first trench.

As shown in FIG. 3, FIG. 3 is a schematic structural diagram of forming a gate insulating layer and a first gate material layer according to a first embodiment of the present disclosure.

As shown in FIG. 3, the gate insulating layer 200 is formed on the surface of the substrate 110 and sidewalls of the first trench 101. The first gate material layer 300 is covered on the gate insulating layer 200. The first gate material layer 300 fills the first trench 101. In this way, the gate insulating layer 200 and the first gate material layer 300 cover both the surface of the substrate 110 and the sidewalls of the first trench 101.

In some embodiments, after the first gate material layer 300 is formed, a chemical mechanical polishing process is performed on a surface of the first gate material layer 300 to planarize the surface of the first gate material layer 300.

The part of the first gate material layer and the part of the gate insulating layer are removed to form the contact window on the surface of the substrate. The second gate is formed on the contact window. The second gate contacts the substrate and has a continuous lattice structure with the substrate.

Block S13 in the embodiment may include the following operations.

The first gate material layer 300 and the gate insulating layer 200 are patterned to form the contact window on the surface of the substrate 110 to expose a part of the substrate 110.

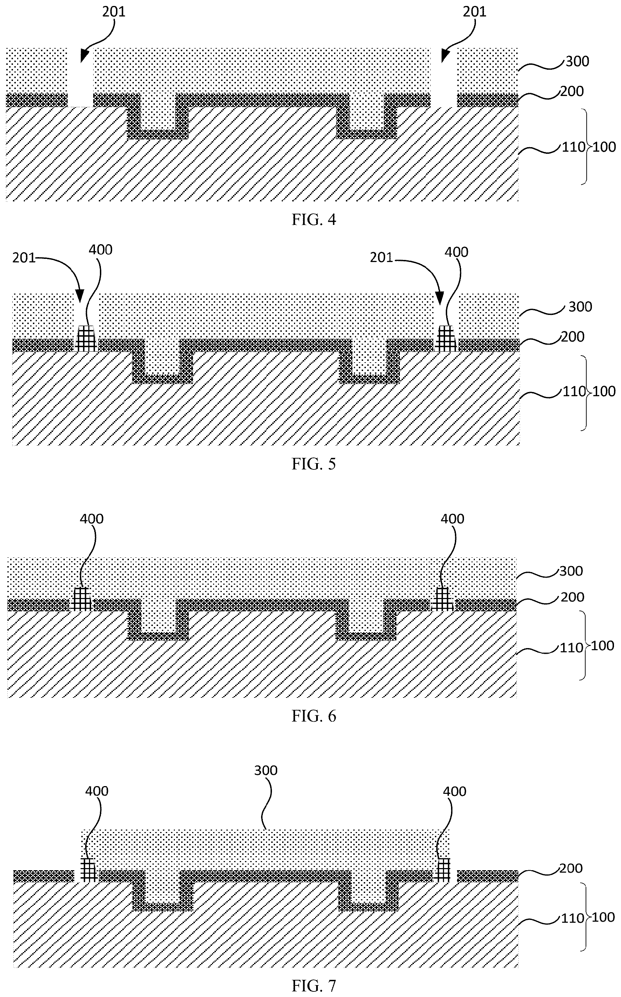

As shown in FIG. 4, FIG. 4 is a schematic structural diagram of forming a contact window according to a first embodiment of the present disclosure.

As shown in FIG. 4, on one side of each of the first trenches 101, the first gate material layer 300 and the gate insulating layer 200 are patterned to form a second trench 201. A bottom of the second trench 201 exposes the part of the substrate 110 to form a corresponding contact window.

In some embodiments, patterning may be performed using photolithography, and dry etching and/or wet etching.

Before forming the second gate, the part of the substrate 110 is exposed after patterning, and a native oxide layer may form on the part of the substrate 110. Therefore, the method further includes the following operations.

The native oxide layer naturally formed on the part of the substrate 110 exposed by the contact window is removed.

The removing the native oxide layer formed naturally on the part of the substrate 110 needs to be performed within a certain temperature range and under a corresponding reaction gas. The native oxide layer is removed using a first reaction gas within a first temperature range, such as 900 to 1000 degrees Celsius.

In some embodiments, the first reaction gas may be a gas that reacts with the native oxide layer to remove the native oxide layer, such as hydrogen gas, HF gas, etc. Alternatively, the first reaction gas may be a combination of two or more gases.

A second reaction gas and a third reaction gas are used to epitaxially grow a second gate material on the part of the substrate 110, and the second gate material is used as the second gate 400. The second reaction gas may be a silicon source gas, such as silane gas (SiH₄), dichlorosilane (SiH₂Cl₂), or a combination of two or more gases. The third reaction gas may be hydrogen chloride gas (HCl). The removing the native oxide layer and the epitaxially growing the second gate material are performed in the same chamber to avoid a new oxide layer being formed during a transferring process from a chamber to another chamber after the native oxide layer is removed.

At 900 to 1000 degrees Celsius, hydrogen and/or HF gas is used to remove the native oxide layer. A silicon source gas is used to grow the second gate material, serve as the second gate 400, in the second trench 201 by means of epitaxial growth, and hydrogen chloride gas is introduced simultaneously, so that the second gate material grows only in the part of the substrate 110.

As shown in FIG. 5, FIG. 5 is a schematic structural diagram of growing a second gate according to a first embodiment of the present disclosure.

As shown in FIG. 5, on the basis of FIG. 4, the silicon source gas, such as silane gas (SiH₄) and/or dichlorosilane (SiH₂Cl₂) is used to grow the second gate material in the second trench 201, where the part of the substrate is exposed, by means of epitaxial growth. At the same time, hydrogen chloride gas (HCl) is introduced so that the second gate material grows only on the part of the substrate 110. The second gate material is grown to be used as the second gate 400. The second gate 400 has a continuous lattice structure with the substrate 110.

The first gate material may be a polycrystalline material, such as polycrystalline silicon. The second gate material may be a single crystal material, such as single crystal silicon.

The single crystal silicon is grown on the single crystal silicon substrate in the second trench 201 by means of epitaxial growth to serve as the second gate 400, making the second gate 400 and the substrate 110 have the continuous lattice structure.

In some embodiments, after forming the second gate 400, a first gate material is continuously formed in the same chamber. The first gate material is continuously formed and fills the second trench 201, i.e., the second trench 201 on the contact window, formed by patterning the first gate material layer 300, to complete the first gate material layer 300.

As shown in FIG. 6, FIG. 6 is a schematic structural diagram of continuously forming a first gate material according to a first embodiment of the present disclosure.

As shown in FIG. 6, after the second gate 400 is formed, an introduction of the hydrogen chloride gas is stopped, and the first gate material is continuously grown in the second trench 201, so that the first gate material fills the second trench 201. The continuously grown first gate material is chemically mechanically polished to make a surface of the first gate material flat, that is, the filled first gate material is planarized to form the first gate material layer 300.

In some embodiments, the first gate material is a polycrystalline material, such as polycrystalline silicon. The second gate material is a single crystal material, such as single crystal silicon.

In some embodiments, after continuously growing the first gate material, a P-type gate structure may be formed by means of ion implantation.

In some embodiments, the second gate 400 is formed on the contact window to fill the second trench 201, and a chemical mechanical polishing is performed on a surface of the second gate 400 to make the surface flat.

The island structure is formed. The island structure covers the first trench. The portion of the first gate material layer remaining in the island structure serves as the first gate. The first gate contacts a corresponding second gate and is separated from the substrate by the gate insulating layer. The first gate and the second gate constitute the semi-floating gate of the memory cell in the memory device.

Block S14 in the embodiment may include the following operations.

Patterning is performed on the first gate material layer. An inter-gate dielectric layer is formed on the remaining first gate material layer, the second gate, and the gate insulating layer. A third gate material layer is formed on the inter-gate dielectric layer. The third gate material layer and the inter-gate dielectric layer are patterned to form the island structure.

A portion of the third gate material layer remaining in the island structure serves as a third gate, and the third gate is separated from the first gate and the second gate by the remaining inter-gate dielectric layer.

As shown in FIG. 7, FIG. 7 is a schematic structural diagram of patterning a first gate material layer according to a first embodiment of the present disclosure.

As shown in FIG. 7, on the basis of FIG. 6, patterning is performed on the first gate material layer 300. In this embodiment, the first gate material layer 300 after patterning exposes a side of the second gate 400.

The patterning process may be performed using photolithography, and dry etching and/or wet etching.

In some embodiments, a part of the first gate material layer 300 is removed in a patterned area to expose a part of the gate insulating layer 200 and a part of the substrate 110 to form a first island structure. A portion of the substrate on a side of the exposed side of the second gate 400 is also exposed.

In some embodiments, the patterning process may be performed inside, outside, or at a boundary of the second trench 201. In a case where the patterning process is performed inside the second trench 201, both a portion of the first gate material layer 300 and a portion of the second gate 400 inside the second trench 201 are removed. In a case where the patterning process is performed outside or at the boundary of the second trench 201, both the portion of the first gate material layer 300 and the portion of the second gate 400 inside the second trench 201 are remained, and a portion of the first gate material layer 300 outside the second trench 201 is removed.

The inter-gate dielectric layer is formed on the first island structure.

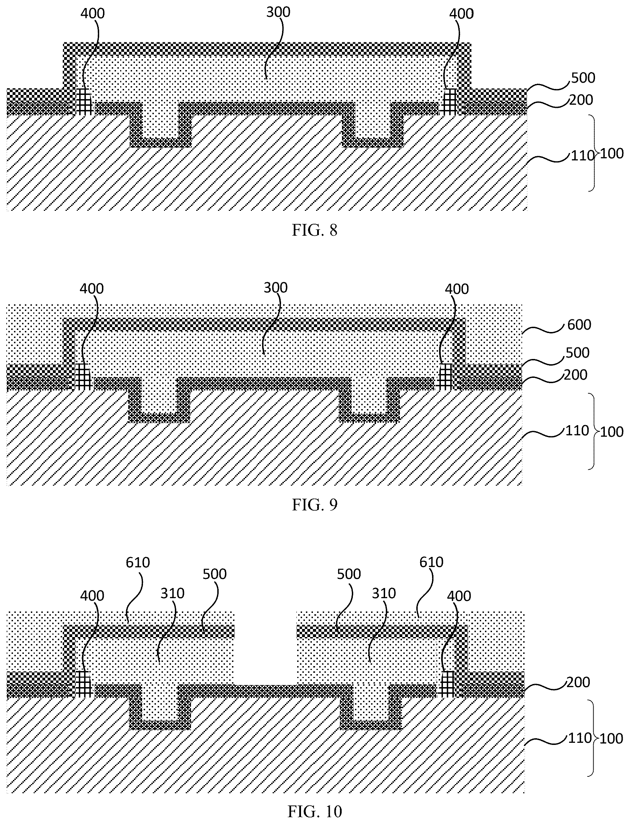

As shown in FIG. 8, FIG. 8 is a schematic structural diagram of forming an inter-gate dielectric layer according to a first embodiment of the present disclosure.

As shown in FIG. 8, on the basis of FIG. 7, after patterning, the inter-gate dielectric layer 500 is formed on the remaining first gate material layer 300, the second gate 400, and the gate insulating layer 200, so that the inter-gate dielectric layer 500 covers the first gate material layer 300, the second gate 400, and the gate insulating layer 200.

In some embodiments, in a case where a portion of the substrate 110 is exposed in the patterned area, the inter-gate dielectric layer 500 may also cover the portion of the substrate 110.

In some embodiments, the inter-gate dielectric layer may be a multi-layer structure, such as a two-layer structure including an oxide layer and a nitride layer, such as a silicon oxide layer and a silicon nitride layer to form an ON structure.

The third gate material layer is formed on the inter-gate dielectric layer 500.

As shown in FIG. 9, FIG. 9 is a schematic structural diagram of forming a third gate material layer according to a first embodiment of the present disclosure.

As shown in FIG. 9, on the basis of FIG. 8, the third gate material layer 600 is formed on the inter-gate dielectric layer 500, making the third gate material layer 600 covers the inter-gate dielectric layer 500. The third gate material layer 600 is chemically mechanically polished, making a surface of the third gate material layer 600 flat.

The third gate material layer 600 and the inter-gate dielectric layer 500 are patterned to form a second island structure.

As shown in FIG. 10, FIG. 10 is a schematic structural diagram of forming a second island structure according to a first embodiment of the present disclosure.

As shown in FIG. 10, on the basis of FIG. 9, the third gate material layer 600 and the inter-gate dielectric layer 500 are patterned to remove a portion of the third gate material layer 600, a portion of the inter-gate dielectric layer 500, and a portion of the first gate material layer 300 on a side of the first trench 101 away from the second gate 400, thereby forming the second island structure. The third gate material layer 600 remaining in the second island structure serves as the third gate 610, and the first gate material layer 300 remaining in the second island structure serves as the first gate 310. The third gate 610 is separated from the first gate 310 and the second gate 400 by the remaining inter-gate dielectric layer 500.

In some embodiments, the first gate 310 and the second gate 400 in the second island structure serve as the semi-floating gate of the memory cell in the memory device. The semi-floating gate contacts the substrate 110 through the second gate 400. The second gate 400 has a corresponding contact window in contact with the substrate, and the rest of the semi-floating gate is separated from the substrate by the gate insulating layer 200. The third gate 610 in the second island structure serves as a control gate of the memory cell in the memory device, and is separated from the semi-floating gate by the inter-gate dielectric layer 500.

During the process of forming the second gate 400, the native oxide layer at the contact window is removed under a vacuum state, thereby making the second gate 400 epitaxially grow on an interface of the single crystal silicon substrate. In this way, the interfaces of the contact windows are uniform. The second gate 400 and the substrate 110 have the continuous lattice structure, thereby effectively improving the interface flatness of the contact window in the semi-floating gate structure and enhancing the storage performance of the memory device.

In some embodiments, a sidewall may be arranged on each of two sides of the island structure.

In some embodiments, ion implantation is performed on the substrate to form a source region and a drain region in the substrate on the two sides of the island structure respectively. For example, a common source region is formed in the substrate 110 between two island structures and two drain regions are formed in the substrate 110 on other sides of the two island structures respectively.

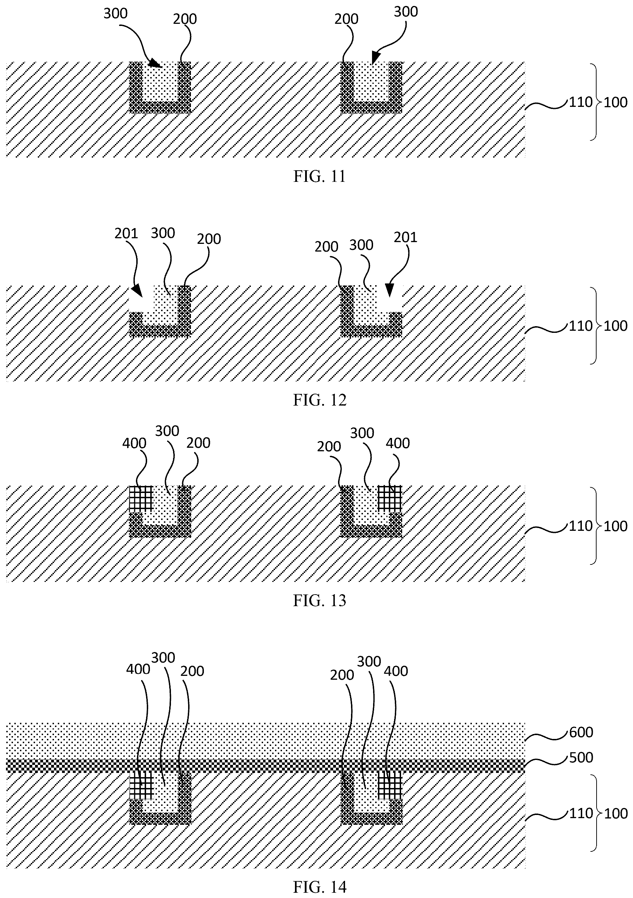

FIG. 11 to FIG. 15 are schematic structural diagrams of a manufacturing method for a memory device according to a second embodiment of the present disclosure.

In the second embodiment, the same operations as those of the first embodiment are not described in detail herein, and operations different from the first embodiment are described in detail as follows.

At block S21, a semiconductor base is provided, and the semiconductor base includes a substrate and a first trench formed from a surface of the substrate toward the substrate.

At block S22, a gate insulating layer and a first gate material layer are formed in the first trench, and the first gate material layer fills the first trench.

As shown in FIG. 11, FIG. 11 is a schematic structural diagram of forming a gate insulating layer and a first gate material layer according to a second embodiment of the present disclosure.

As shown in FIG. 11, the semiconductor base 100 includes the substrate 110 and the first trench 101 formed from the surface of the substrate toward the substrate. The gate insulating layer 200 is formed on sidewalls of the first trench 101. The first gate material layer 300 is formed on the gate insulating layer 200, and the first gate material layer 300 fills the first trench 101. In this way, the gate insulating layer 200 covers the first trench 101, and the first gate material layer 300 covers the first trench 101.

At block S23, a part of the first gate material layer and a part of the gate insulating layer are removed to form a contact window on a sidewall of the first trench; a second gate is formed on the contact window, and the second gate contacts the substrate and has a continuous lattice structure with the substrate.

As shown in FIG. 12, FIG. 12 is a schematic structural diagram of forming a contact window according to a second embodiment of the present disclosure.

As shown in FIG. 12, a portion of the first gate material layer 300 and a portion of the gate insulating layer 200 within the first trench 101 are patterned to remove the portion of the first gate material layer 300 and the portion of the gate insulating layer 200 within the first trench 101, forming a second trench 201. A portion of the substrate 110 is exposed through the second trench 201 to form a corresponding contact window.

As shown in FIG. 13, FIG. 13 is a schematic structural diagram of forming a second gate according to a second embodiment of the present disclosure.

As shown in FIG. 13, the contact window is processed by the processing method in the first embodiment to form the second gate 400 on the contact window, so that the second gate 400 is in contact with the substrate through the contact window.

In some embodiments, the second gate 400 fills the second trench 201, thereby making the second gate 400 flush with the substrate 110.

In some embodiments, in a case where the second trench 201 is not filled after the second gate 400 is grown, the first gate material is continuously grown on the second gate 400 to fill the second trench 201, making the first gate material layer flush with the substrate 110.

At block S24, an island structure is formed, the island structure covers the first trench, a portion of the first gate material layer remaining in the island structure serves as a first gate, the first gate contacts the second gate and is separated from the substrate by the gate insulating layer, and the first gate and the second gate constitute a semi-floating gate of a memory cell in the memory device.

Before forming the island structure, it is necessary to form an inter-gate dielectric layer 500 and a third gate material layer 600. The operations of forming the island structure include: forming the inter-gate dielectric layer 500 on both the first gate material layer 300 and the second gate 400; forming the third gate material layer 600 on the inter-gate dielectric layer 500, and patterning the third gate material layer 600 and the inter-gate dielectric layer 500 to form the island structure. The third gate material layer remaining in the island structure serves as the third gate 610, and the third gate 610 is separated from the first gate 310 and the second gate 400 by the remaining inter-gate dielectric layer 500.

As shown in FIG. 14, FIG. 14 is a schematic structural diagram of forming an inter-gate dielectric layer and a third gate material layer according to a second embodiment of the present disclosure.

As shown in FIG. 14, on the basis of FIG. 13, the inter-gate dielectric layer 500 is formed on the surface of the substrate 110, the second gate 400, the first gate material layer 300, and the gate insulating layer 200. The third gate material layer 600 is formed on the inter-gate dielectric layer 500. That is, the inter-gate dielectric layer 500 covers the surface of the substrate 110, and the second gate 400, the first gate material layer 300, and the gate insulating layer 200 exposed through the surface of the substrate 110, and the third gate material layer 600 covers the inter-gate dielectric layer 500.

The third gate material layer 600 is patterned to form the island structure.

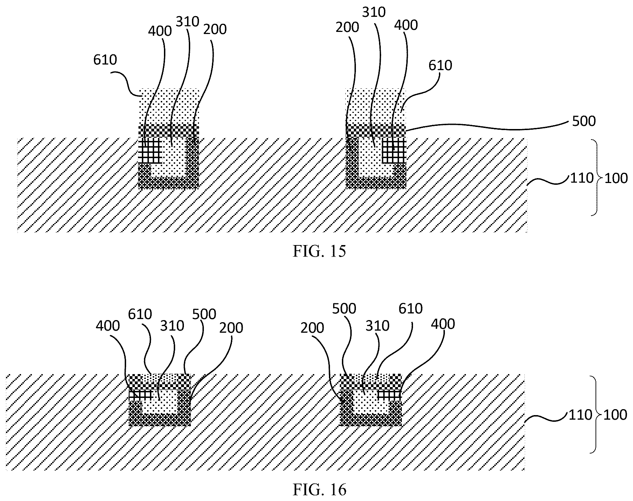

As shown in FIG. 15, FIG. 15 is a schematic structural diagram of forming an island structure according to a second embodiment of the present disclosure.

As shown in FIG. 15, on the basis of FIG. 14, the third gate material layer 600 and the inter-gate dielectric layer 500 are patterned to remove a part of the third gate material layer 600 and a part of the inter-gate dielectric layer 500 on a side of the first trench 101, thereby forming the island structure. A portion of the third gate material layer 600 remaining in the island structure serves as the third gate 610, and a portion of the first gate material layer 300 remaining in the first trench 101 serves as the first gate 310. The third gate 610 is separated from the first gate 310 and the second gate 400 by the remaining inter-gate dielectric layer 500.

As shown in FIG. 16, FIG. 16 is a schematic structural diagram of forming an inter-gate dielectric layer and a third gate material layer according to a third embodiment of the present disclosure.

In some embodiments, as shown in FIG. 16, after the operations shown in FIG. 13, a height of the first gate and a height of the second gate may be lowered, making the semi-floating gate structure including the first gate and the second gate is located at a lower part of the first trench. An inter-gate dielectric layer and a third gate material layer are formed on the semi-floating gate structure so that a subsequently formed third gate (i.e., a control gate) is located in the first trench, thereby forming a buried gate structure.

The present disclosure also provides a memory device, including a substrate, a trench, and an island structure. The trench extends from a surface of the substrate toward the substrate. The island structure at least fills the trench. The island structure includes a first gate and a second gate. The second gate contacts the substrate through a contact window and has a continuous lattice structure with the substrate. The first gate is separated from the substrate by a gate insulating layer. The first gate and the second gate constitute a semi-floating gate of a memory cell in the memory device. The contact window is located on the surface of the substrate or on a sidewall of the trench.

In some embodiments, the memory device further includes an inter-gate dielectric layer and a third gate. The inter-gate dielectric layer is located on the first gate, the second gate, and the gate insulating layer. Alternatively, the inter-gate dielectric layer is located on the first gate and the second gate. The third gate is located on the inter-gate dielectric layer. The third gate constitutes a control gate of the memory cell in the memory device. In this way, the semi-floating gate and the control gate constitute a semi-floating gate transistor.

In some embodiments, the memory device further includes a sidewall, and the sidewall is arranged on each of two sides of the island structure.

In some embodiments, the semi-floating gate and the third gate are located in the trench.

In some embodiments, a material of the first gate is polycrystalline silicon, and a material of the second gate is single crystal silicon.

In some embodiments, multiple doped regions and a plurality of shallow trench isolation structures for isolating memory cells in the memory device are formed in the substrate. The doped regions are located on a side of the substrate. The doped regions include a first doping type and/or a second doping type, and the first doping type is opposite to the second doping type.

In some embodiments, the number of semi-floating gate transistors in the memory device may be more than one, for example, may be 2, 3, 4, etc.

In the present disclosure, the manufacturing method for the memory device includes: providing a semiconductor base, wherein the semiconductor base comprises a substrate and a first trench formed from a surface of the substrate toward the substrate; forming a gate insulating layer and a first gate material layer on the surface of the substrate and in the first trench, or forming a gate insulating layer and a first gate material layer in the first trench, wherein the first gate material layer fills the first trench; removing a part of the first gate material layer and a part of the gate insulating layer to form a contact window on the surface of the substrate or on a sidewall of the first trench, and forming a second gate on the contact window, wherein the second gate contacts the substrate and has a continuous lattice structure with the substrate; forming an island structure, wherein the island structure covers the first trench, a portion of the first gate material layer remaining in the island structure serves as a first gate, the first gate contacts the second gate and is separated from the substrate by the gate insulating layer, and the first gate and the second gate constitute a semi-floating gate of a memory cell in the memory device. Through the manufacturing method, the second gate has a continuous lattice structure with the substrate, making an interface of the contact window corresponding to the semi-floating gate and the substrate uniform, thereby effectively improving the interface flatness of the contact window in the semi-floating gate structure and enhancing the storage performance of the memory device.

The above description is only some embodiments of the present disclosure, and does not limit the patent scope of the present disclosure. Any equivalent structure or equivalent process transformation made by using the contents of the description and drawings of the present disclosure, or directly or indirectly applied in other related technical fields, is included in the patent protection scope of the present disclosure.

## Claims

1. A manufacturing method for a memory device, comprising:
providing a semiconductor base, wherein the semiconductor base comprises a substrate and a first trench formed from a surface of the substrate toward the substrate;
forming a gate insulating layer and a first gate material layer on the surface of the substrate and in the first trench, or forming a gate insulating layer and a first gate material layer in the first trench, wherein the first gate material layer fills the first trench;
removing a part of the first gate material layer and a part of the gate insulating layer to form a contact window on the surface of the substrate or on a sidewall of the first trench, and forming a second gate on the contact window, wherein the second gate contacts the substrate and has a continuous lattice structure with the substrate;
forming an island structure, wherein the island structure covers the first trench, a portion of the first gate material layer remaining in the island structure serves as a first gate, the first gate contacts the second gate and is separated from the substrate by the gate insulating layer, and the first gate and the second gate constitute a semi-floating gate of a memory cell in the memory device.

2. The method according to claim 1, wherein the removing a part of the first gate material layer and a part of the gate insulating layer to form a contact window on the surface of the substrate or on a sidewall of the first trench, and forming a second gate on the contact window, comprises:
performing patterning on the first gate material layer and the gate insulating layer to form the contact window on the surface of the substrate or on the sidewall of the first trench for exposing a part of the substrate;
growing the second gate on the contact window, and continuously forming a first gate material to cover the second gate, wherein the first gate material continuously formed at least fills a portion of second trench of the contact window to complete the first gate material layer.

3. The method according to claim 1, wherein before growing the second gate on the contact window, the method further comprises:
removing a native oxide layer naturally formed on the part of the substrate exposed by the contact window.

4. The method according to claim 1, wherein the first gate material is polycrystalline silicon, and a material of the second gate is single crystal silicon.

5. The method according to claim 3, wherein the removing a native oxide layer naturally formed on the part of the substrate exposed by the contact window, comprises:
removing the native oxide layer by using a first reaction gas within a first temperature range, wherein the first temperature range is 900 to 1000 degrees Celsius, and the first reaction gas comprises hydrogen and/or HF gas.

6. The method according to claim 1, wherein the growing the second gate on the contact window, comprises:
epitaxially growing a second gate material on the part of the substrate exposed by the contact window using a second reaction gas and a third reaction gas;
wherein, the second reaction gas comprises silane gas and/or dichlorosilane gas, and the third reaction gas comprises hydrogen chloride gas.

7. The method according to claim 2, wherein the growing the second gate on the contact window, and continuously forming a first gate material to cover the second gate, comprises:
epitaxially and continuously growing the first gate material on the second gate by using a second reaction gas; wherein the second reaction gas comprises silane gas and/or dichlorosilane gas.

8. The method according to claim 3, wherein the removing a native oxide layer and the growing the second gate are performed in the same chamber.

9. The method according to claim 1, wherein the forming an island structure, comprises:
performing patterning on the first gate material layer, and forming an inter-gate dielectric layer on the remaining first gate material layer, the second gate, and the gate insulating layer; or, forming an inter-gate dielectric layer on the first gate material layer and the second gate;
forming a third gate material layer on the inter-gate dielectric layer, and patterning the third gate material layer and the inter-gate dielectric layer to form the island structure;
wherein a portion of the third gate material layer remaining in the island structure serves as a third gate, and the third gate is separated from the first gate and the second gate by the remaining inter-gate dielectric layer.

10. The method according to claim 9, wherein the inter-gate dielectric layer comprises an oxide layer and a nitride layer.

11. A memory device, comprising:
a substrate;
a trench, extending from a surface of the substrate toward the substrate;
an island structure, at least filling the trench, wherein the island structure comprises a first gate and a second gate, the second gate contacts the substrate through a contact window and has a continuous lattice structure with the substrate, the first gate is separated from the substrate by a gate insulating layer, the first gate and the second gate contact with each other and constitute a semi-floating gate of a memory cell in the memory device, and the contact window is located on the surface of the substrate or on a sidewall of the trench.

12. The memory device according to claim 11, further comprising:
an inter-gate dielectric layer, located on the first gate, the second gate, and the gate insulating layer;
a third gate, located on the inter-gate dielectric layer, wherein the third gate constitutes a control gate of the memory cell in the memory device.

13. The memory device according to claim 11, further comprising:
a sidewall, arranged on each of two sides of the island structure.

14. The memory device according to claim 12, wherein the semi-floating gate and the third gate are located in the trench.

15. The memory device according to any one of claims 11 to 14, wherein a material of the first gate is polycrystalline silicon, and a material of the second gate is single crystal silicon.
